# EUROPÄISCHE PATENTSCHRIFT

(11) **EP 3 555 648 B1**
(45) Veröffentlichungstag und Bekanntmachung des Hinweises auf die Patenterteilung: **16.09.2020**
(21) Anmeldenummer: 17811433.6
(22) Anmeldetag: 24.11.2017
(51) Int. Cl.: G01R 33/34, G01R 33/36, H01Q 1/27, H01Q 21/20, G01R 33/422, G01R 33/48, H01Q 9/16, H01Q 21/26

(54) **DIPOLANTENNENANORDNUNG FÜR DIE AUFNAHME VON BILDERN MIT KERNMAGNETISCHEN RESONANZMETHODEN**
DIPOLE ANTENNA ASSEMBLY FOR CAPTURING IMAGES BY MEANS OF NUCLEAR MAGNETIC RESONANCE METHODS
SYSTÈME À ANTENNES DIPÔLES POUR LA CAPTURE D'IMAGES AU MOYEN DE MÉTHODES DE RÉSONANCE MAGNÉTIQUE NUCLÉAIRE

(30) Priorität: 15.12.2016 DE 102016014978
(43) Veröffentlichungstag der Anmeldung: 23.10.2019
(73) Patentinhaber: Forschungszentrum Jülich GmbH, 52425 Jülich (DE)
(72) Erfinder: FELDER, Jörg, 52428 Jülich (DE); HONG, Suk Min, 52428 Jülich (DE); SHAH, Nadim Joni, 52428 Jülich (DE); MAGILL, Arthur William, 69181 Leimen (DE)
(86) Internationale Anmeldenummer: PCT/DE2017/000402
(87) Internationale Veröffentlichungsnummer: WO 2018/108193

(56) Entgegenhaltungen:
- PENG JIN ET AL: "Multi-Frequency, Linear and Circular Polarized, Metamaterial-Inspired, Near-Field Resonant Parasitic Antennas", IEEE TRANSACTIONS ON ANTENNAS AND PROPAGATION., Bd. 59, Nr. 5, 3. März 2011 (2011-03-03), Seiten 1446-1459, XP055456576, US ISSN: 0018-926X, DOI: 10.1109/TAP.2011.2123053
- WIGGINS G.C. ET AL.: "Mixing loops and electric dipole antennas for increased sensitivity at 7 Tesla", PROCEEDINSG OF THE INTERNATIONAL SOCIETY FOR MAGNETIC RESONANCE IN MEDICINE, 21ST ANNUAL MEETING & EXHIBITION, 7. April 2013 (2013-04-07), Seite 2737, XP040630333, Salt Lake City, Utah, USA
- JINFENG TIAN ET AL: "Design considerations for dipole for head MRI at 10.5T", 2015 IEEE MTT-S 2015 INTERNATIONAL MICROWAVE WORKSHOP SERIES ON RF AND WIRELESS TECHNOLOGIES FOR BIOMEDICAL AND HEALTHCARE APPLICATIONS (IMWS-BIO), 21. September 2015 (2015-09-21), Seiten 99-100, XP055456335, DOI: 10.1109/IMWS-BIO.2015.7303796 ISBN: 978-1-4799-8543-2
- G. SHAJAN ET AL: "Three-layered radio frequency coil arrangement for sodium MRI of the human brain at 9.4 Tesla : RF Coil for 23 Na MRI at 9.4T", MAGNETIC RESONANCE IN MEDICINE., Bd. 75, Nr. 2, 11. März 2015 (2015-03-11), Seiten 906-916, XP055456391, US ISSN: 0740-3194, DOI: 10.1002/mrm.25666 in der Anmeldung erwähnt
- W. KONING ET AL: "High-resolution MRI of the carotid arteries using a leaky waveguide transmitter and a high-density receive array at 7 T", MAGNETIC RESONANCE IN MEDICINE., Bd. 69, Nr. 4, 3. Juli 2012 (2012-07-03), Seiten 1186-1193, XP055456343, US ISSN: 0740-3194, DOI: 10.1002/mrm.24345
- HONG S.-M. ET AL.: "A bent dipole antenna and 4-channel loop array for 1H/31P brain application at 3 T MRI", INTERNATIONAL SOCIETY FOR MAGNETIC RESONANCE IN MEDICINE, ISMRM, 2030 ADDISON STREET, 7TH FLOOR, BERKELEY, CA 94704 USA, Nr. 4320, 7. April 2017 (2017-04-07), XP040691888,
- M. ARCAN ERTÜRK ET AL: "A 16-channel combined loop-dipole transceiver array for 7 Tesla body MRI", MAGNETIC RESONANCE IN MEDICINE., Bd. 77, Nr. 2, 17. Februar 2016 (2016-02-17), Seiten 884-894, XP055456339, US ISSN: 0740-3194, DOI: 10.1002/mrm.26153
- CELAL OEZERDEM ET AL: "16-channel bow tie antenna transceiver array for cardiac MR at 7.0 tesla", MAGNETIC RESONANCE IN MEDICINE., Bd. 75, Nr. 6, 17. Juli 2015 (2015-07-17), Seiten 2553-2565, XP055456348, US ISSN: 0740-3194, DOI: 10.1002/mrm.25840

## Beschreibung

Die Erfindung betrifft eine Dipolantennenanordnung für die Aufnahme von Bildern mit kernmagnetischen Resonanzmethoden.

Bei der Magnetresonanztomographie (MRT) werden in der Regel Resonanzaufnahmen von Protonen gemessen. Um ergänzende Informationen zu erlangen, werden auch Bilder aufgenommen, die mit Bildgebungsmethoden unter Anregung von X-Kernen generiert werden. Bei X-Kernen handelt es sich um NMR-aktive Kerne, die von Wasserstoffkernen verschieden sind. Diese sind dem Fachmann bekannt. Beispielsweise werden 23Na Kerne oder 31P Kerne eingesetzt. Die Aufnahmen mit den X-Kernen werden meist zeitlich getrennt von den Aufnahmen mit den H-Kernen gemacht. Messungen von X-Kernen erzeugen zumeist komplementäre Informationen zur Messung an Wasserstoffkernen. Beispiele für zusätzliche Informationen, welche X-Kern Messungen liefern, sind metabolische Informationen oder Aussagen über die Zellviabilität. Jedoch sind X-Kern Signale in der MRT signifikant niedriger als Protonensignale. Deshalb werden zur Verbesserung von X-Kern Messungen häufig 1H Messungen durchgeführt. Beispiele für kombinierte Messungen mit Hilfe des Protonenkanals sind Scout Bilder und B₀ Shimming. Die MRT wird in der Medizin derzeit üblicherweise mit Geräten die eine Feldstärke zwischen 0,25T und 4T verwenden, betreiben. Geräte mit einer Feldstärke von 7T für den klinischen Bereich befinden sich in der Entwicklung. Prinzipiell sind jedoch alle Magnetfeldstärken verwendbar, bedürfen jedoch ggf. einer Sondergenehmigung für den Betrieb.

Zur Durchführung von kombinierten X/1H- Messungen sind verschiedene Methoden zum Bau von doppelt oder dreifach abgestimmten MRT Spulenanordnungen bekannt. Ein Problem ist dabei die Entkopplung der Protonen und X-Kern Resonanzen der Spulen. Hierfür sind bereits verschiedene Verfahren und Vorrichtungen bekannt.

Eine Entkopplung der Spulen mittels Sperrkreisen, z.B. doppelt abgestimmte Birdcage-Resonatoren mit passiven Sperrkreisen meist auf alternierenden Beinen ist in den Veröffentlichungen von Shen GX, Wu J f., Boada FE, Thulborn KR. Experimentally verified, theoretical design of dual-tuned, low-pass birdcage radiofrequency resonators for magnetic resonance imaging and magnetic resonance spectroscopy of human brain at 3.0 Tesla. Magn. Reson. Med. 1999;41:268-275. doi: 10.1002/(SICI)1522-2594(199902)41:2<268::AID-MRM9>3.O.CO;2-G, Meyerspeer M, Roig ES, Gruetter R, Magill AW. An improved trap design for decoupling multinuclear RF coils. Magn. Reson. Med. 2013:n/a-n/a. doi: 10.1002/mrm.24931 und Dabirzadeh A, McDougall MP. Trap design for insertable secondnuclei radiofrequency coils for magnetic resonance imaging and spectroscopy. Concepts Magn. Reson. Part B Magn. Reson. Eng. 2009;35B:121-132. doi: 10.1002/cmr.b.20139. dargestellt.

Eine Entkopplung mittels PIN Dioden, z.B. zwei unabhängige RF Spulen, die abwechselnd verstimmt werden, wird in der Veröffentlichung Ha S, Hamamura MJ, Nalcioglu O, Muftuler LT. A PIN diode controlled dual-tuned MRI RF coil and phased array for multi nuclear imaging. Phys. Med. Biol. 2010;55:2589-2600. doi: 10.1088/0031-9155/55/9/011 offenbart.

Eine geometrische Entkopplung, z.B. "Butterfly Spule" und zentrierter Oberflächenspulen wird in den Veröffentlichungen Bottomley PA, Hardy CJ, Roemer PB, Mueller OM. Protondecoupled, overhauser-enhanced, spatially localized carbon-13 spectroscopy in humans. Magn. Reson. Med. 1989;12:348-363. doi: 10.1002/mrm.1910120307., Adriany G, Gruetter R. A half-volume coil for efficient proton decoupling in humans at 4 tesla. J. Magn. Reson. San Diego Calif 1997 1997;125:178-184. doi: 10.1006/jmre. 1997.1113 dargestellt.

Ein weiterer Lösungsansatz sind modifizierte Resonator Strukturen, z.B. Birdcage Resonatoren mit zusätzlichen Endringen, wie sie in Potter W m., Wang L, McCully K k., Zhao Q. Evaluation of a new 1H/31P dual-tuned birdcage coil for 31P spectroscopy. Concepts Magn. Reson. Part B Magn. Reson. Eng. 2013;43:90-99. doi: 10.1002/cmr.b.21239 beschrieben sind.

Der Artikel Tian J. et al.: "Design considerations for Dipole for Head MRI at 10.5 T", International Microwave Workshop Series on RF and Wireless Technologies for Biomedical and Healthcare Applications, 21.09.2015, Seiten 99-100, beschreibt eine Spulenanordnung, in welcher Dipolantennen im Design an eine Kopfgeometrie angepasst sind.

Dipol- und Monopolantennen können in doppelt abgestimmten Systemen in Kombination mit Oberflächenspulen verwendet werden. Werden sie in der Mitte der Oberflächenspule angeordnet, so resultiert aufgrund der Magnetfelder beider Leiteranordnung ein verschwindender gekoppelter magnetischer Fluß (Shajan G, Mirkes C, Buckenmaier K, Hoffmann J, Pohmann R, Scheffler K. Three-layered radio frequency coil arrangement for sodium MRI of the human brain at 9.4 Tesla. Magn. Reson. Med. 2015:n/a-n/a. doi: 10.1002/mrm.25666, Yan X, Wei L, Xue R, Zhang X. Hybrid Monopole/Loop Coil Array for Human Head MR Imaging at 7 T. Appl. Magn. Reson. 2015:1-10. doi: 10.1007/s00723-015-0656-5. Yan X, Xue R, Zhang X. A monopole/loop dual-tuned RF coil for ultrahigh field MRI. Quant. Imaging Med. Surg. 2014;4:225-231). Dieser Entkopplungsmechanismus zwischen Mono/Dipol- und Oberflächenspulen beruht demzufolge auch auf einer geometrischen Entkopplung.

Alle Methoden, bis auf die geometrische Entkopplung, erfordern das Einbringen von zusätzlichen Komponenten in die Schwingkreise von ansonsten monofrequenten Spulen was mit zusätzlichen Verlusten verbunden ist. Sie führen zu einer Verminderung der Güte der HF-Spule und damit zur Reduktion des SNR im aufgenommenen MR Signal. Gleichzeitig steigen die Produktionskosten durch höhere Bauteilkosten und aufwendige Abstimmung der Sperrkreise bzw. Abstimmeinheiten.

Es ist daher die Aufgabe der Erfindung ein Verfahren und eine Vorrichtung zu schaffen, die die Entkopplung von 1H/X-Kern Resonanzen auf einfache Weise und kostengünstig ermöglicht und dabei die Güte der HF-Spule nicht beeinträchtigt. Das Verfahren und die Vorrichtung sollen insbesondere im klinisch relevanten Anwendungsbereich unterhalb von 4 Tesla anzuwenden sein.

Ausgehend vom Oberbegriff des Anspruchs 1 wird die Aufgabe erfindungsgemäß gelöst mit den im kennzeichnenden Teil des Anspruchs angegebenen Merkmalen.

Mit der erfindungsgemäßen Vorrichtung und dem erfindungsgemäßen Verfahren ist es nunmehr möglich, eine Entkopplung der Spulenresonanzen von 1H und X-Kern Frequenzen auch bei klinisch relevanten Feldstärken unter Verwendung von Dipolantennen und Oberflächenspulen zu ermöglichen. Dabei wird die Güte der verwendeten HF-Spulen nicht verringert.

Vorteilhafte Weiterbildungen der Erfindung sind in den Unteransprüchen angegeben. Erfindungsgemäß wird eine Dipolantennenanordnung zur Verfügung gestellt, welche um ein Körperteil eines Patienten, insbesondere um den Kopf, angeordnet werden kann um MR-Signale verschiedener Kerne anzuregen oder aufzunehmen.

Gemäß der Erfindung wird eine Anordnung von mindestens zwei Dipolantennen zur Verfügung gestellt, welche um ein Körperteil eines Patienten, z.B. den Kopf, angeordnet werden kann um MR Signale anzuregen oder aufzunehmen. Dazu werden mindestens zwei Dipolantennen mechanisch, jedoch nicht elektrisch so miteinander verbunden, dass sie sich an einem Punkt kreuzen und Winkel zueinander einschließen. Vorzugsweise werden gleiche Winkel eingeschlossen. So können 2, 3, 4 oder mehr, beispielsweise 16 Dipolantennen, in dieser Weise angeordnet werden. Bei mehr als zwei Dipolantennen in einer Anordnung kann eine Verbesserung der zirkularen Polarisation des erzeugten Magnetfeldes erreicht werden. Mehr als zwei Dipolantennen in einer Dipolantennenanordnung können auch in Verfahren zur parallelen Bildgebung, wie z.B. schnelle Bildgebung mit Unterabtastung des k-Raumes, oder der parallelen Anregung verwendet werden.

Die Anzahl der Dipolantennen ist nach oberen Werten lediglich durch praktische Aspekte begrenzt. Soll beispielsweise der Kopf eines Patienten vermessen werden, so ist eine Anordnung wünschenswert, die das Gesichtsfeld des Patienten nicht einschränkt. Beispielsweise können zwei Dipolantennen in einem Winkel von 90° oder drei Antennen in einem Winkel von jeweils 60° angeordnet werden. Die vom Kreuzungspunkt ausgehenden Teile der Dipolantennen werden als Dipolantennenarme bezeichnet. Die Dipolantennenarme können gleiche oder verschiedene Winkel einschließen.

Erfindungsgemäß besitzt eine Dipolantenne mindestens eine Krümmung, welche dazu führt, dass die Dipolantennenarme in einem Halbraum angeordnet sind und beispielsweise einen Halbkreis, einen Abschnitt eines Ovals oder einer anderen runden Geometrie aber auch eine Spitze bilden. Ebenso kann eine Dipolantenne mindestens zwei Krümmungen aufweisen, die ein in eine Richtung gebogenes Mehreck darstellen, beispielsweise kann die Dipolantenne zwei Biegungen von 90° oder 95° aufweisen oder beispielsweise drei Biegungen, die 60° oder 65° aufweisen. Bei mindestens zwei Biegungen müssen diese nicht gleich groß sein, jedoch sind gleiche Winkel aus Symmetriegründen bevorzugt.

Für alle Ausführungsformen sollen die an dem Kreuzungspunkt befestigten Dipolantennen so angeordnet sein, dass sie mit den Dipolantennenarmen einen Schirm abbilden, der ein Körperteil eines Patienten, beispielsweise einen Kopf wie in einem Käfig, der an einer Seite offen ist, aufnehmen kann.

Die Dipolantennen einer Anordnung kreuzen sich geometrisch vorzugsweise in ihrer Mitte.

Vorzugsweise sind alle Dipolantennenarme gleich lang, so dass der Kreuzungspunkt der Dipolantennen in der Mitte einer Dipolantenne ist, jedoch können einzelne Arme auch gegenüber den anderen Armen länger oder kürzer sein.

In einer bevorzugten Ausführungsform bilden die Dipolantennenarme in dem Halbraum, in dem sie sich befinden, Längslinien eines Zylinders aus, wobei der Begriff des Zylinders im mathematischen Sinne so zu verstehen ist, dass sie parallel zueinander stehen und auf einem kreisförmigen Grundriss oder einem anderen runden Grundriss positioniert sind.

In einer anderen Ausführungsform können die Dipolantennenarme auch Längslinien eines Kegels nachbilden. Beispielsweise schließt der Kegel bzw. der abgeschnittene Kegel einen Winkel zwischen 45° und 120° ein. Die Wahl des Winkels orientiert sich an praktischen Kriterien. Ein Körperteil eines Patienten, beispielsweise der Kopf, soll davon aufgenommen werden können und die erfindungsgemäße Dipolantenne soll so dimensioniert sein, dass sie noch in das MR-Gerät passt.

In einer weiteren Ausführungsform können die Dipolantennen eine Glockenform ausbilden.

Die Arme der Dipolantennen bzw. die Dipolantennenarme beinhalten Kapazitäten oder Induktivitäten, damit eine Resonanzfrequenz zu der zu empfangenen Strahlung hergestellt ist. So kann die Dipolantenne auf die Resonanzfrequenz des ¹H-Kerns oder eines anderen Kerns eingestellt werden. Das Einbringen von Kapazitäten oder Induktivitäten der Resonanzfrequenz ist dem Fachmann bekannt und kann routinemäßig durchgeführt werden.

In einer bevorzugten Ausführungsform verfügt die Dipolantenne über eine Abschirmkappe, welche zum Beispiel am Kreuzungspunkt der Dipolantennen und/oder an den Dipolarmen angebracht ist. Vorteilhaft ist die Abschirmkappe am Einspeisepunkt angebracht, da dort die höchsten konservativen E-Felder auftreten. Die Abschirmkappe kann sich innerhalb der Biegung der Dipolantennen befinden.

Beim Einspeisepunkt handelt es sich um den Punkt einer Dipolantenne, welcher über eine elektrische Leitung mit einem Generator verbunden ist. Jede Dipolantenne benötigt einen Einspeisepunkt, der an einer beliebigen Stelle der Dipolantenne sein kann. Zwischen dem Einspeisepunkt und dem Generator kann eine aktive oder passive Anpassungsschaltung zwischen geschaltet sein.

Die Abschirmkappe ist vorzugsweise ohne Öffnungen und durchgehend geschlossen. Das hat den Vorteil, dass das im Einspeisepunkt der Dipolantennenelemente konzentrierte elektrische Feld gegenüber dem Untersuchungsobjekt abgeschirmt wird. Dies wiederum führt zu einer Reduktion der Erwärmung/SAR des Untersuchungsobjektes. Die Abschirmkappe führt zur Reduktion der SAR aus konservativen E-Feldern, die bei MR-Spulen häufig zu einer Limitierung der mittleren Anregungsleistung führen. Dies schränkt den Anwendungsbereich bezüglich der anwendbaren MRT Sequenzen ein und führt häufig zu längeren Messzeiten.

In einer alternativen Ausführungsform kann die Abschirmkappe auch Öffnungen oder Aussparungen zur Unterdrückung von Wirbelstromeffekten in der MRT besitzen.

Die Abschirmkappe ist vorzugsweise zentrosymmetrisch zum Einspeisepunkt der Dipolantennen fixiert, so dass ausgehend vom Einspeisepunkt der Dipolantennen in einem vorzugsweise gleichmäßigen Radius eine Abschirmung der elektrischen Felder erfolgt.

Die Abschirmkappe kann die Geometrie eines Kugelschnittes, eines Ovals, eines vorzugsweise in eine Rundung gebogenen Mehrecks oder eine andere Geometrie aufweisen.

Die Abschirmkappe hat den Vorteil, dass konservative E-Felder abgeschirmt und elektrische Wirbelfelder geschwächt werden.

Erfindungsgemäß sind an der Dipolantenne Oberflächenspulen angebracht, welche auf die Resonanzfrequenz eines X-Kerns abgestimmt sind.

Dazu sind Oberflächenspulen vorzugsweise so an den Dipolantennenarmen angebracht, dass die Querschnittsfläche der Oberflächenspule durch die Projektion eines Dipolantennenarms auf die Querschnittsfläche entlang einer Symmetrieachse geteilt wird. Dadurch werden die jeweiligen Dipolantennen und Oberflächenspulen entkoppelt.

Entlang der Länge eines Dipolantennenarms können eine oder mehrere Oberflächenspulen angeordnet sein. Mehrere Oberflächenspulen erhöhen die Anzahl der Kanäle für X-Kern Messungen, was z.B. zur Verbesserung des SNR im Empfang verwendet werden kann. Vorzugsweise besitzen alle Dipolantennenarme mindestens eine Spule. Das hat den Vorteil, dass keine Lücken zwischen den X-Kern Oberflächenspulen entlang des Umfangs entstehen. Solche Lücken führen zu Bereichen mit niedriger lokaler Sensitivität, also schlechtem SNR in diesem Bereich.

Die Oberflächenspulen weisen Kapazitäten auf, mit denen die Resonanzfrequenz eingestellt werden kann. Das Einstellen der Resonanzfrequenz ist dem Fachmann geläufig.

In einer Ausführungsform sind alle Oberflächenspulen auf dieselbe Resonanzfrequenz eingestellt, die einem bestimmten zu vermessenden X-Kern entspricht.

In einer anderen Ausführungsform können die Kapazitäten bei verschiedenen Oberflächenspulen unterschiedlich angeordnet sein, so dass sie verschiedene Resonanzfrequenzen haben. Bei dieser Ausführungsform können Signale unterschiedlicher X-Kerne gleichzeitig gemessen werden. In diesem Fall ist jedoch meistens eine zusätzliche Entkopplung der X-Kern Elemente untereinander z.B. durch das Einbringen von Sperrkreisen oder PIN-Dioden erforderlich.

Die Tabellen zeigen physikalische Daten zu Antennen.

### Tabelle 1:

Ein mittleres B1+ Feld bei gleicher Eingangsleistung und maximalem lokalem (10g) SAR normiert auf 1W akzeptierte Leistung pro Anordnung für eine Birdcage-Spule nach dem Stand der Technik und der erfindungsgemäßen Dipolantennen mit und ohne Abschirmkappe.

### Tabelle 2:

Die Entkopplung zwischen Dipolantennen und Oberflächenspulen.

Weiterhin zeigen die Figuren Ausführungsformen von erfindungsgemäßen Dipolantennenanordnungen.

Es zeigt:
- Fig. 1:: eine Dipolantennenanordnung, wie sie in der Erfindung Verwendung finden kann.

- Fig. 2:: Dipolantennenanordnungen ohne Oberflächenspulen mit deren Effizienzen im Vergleich zum Stand der Technik.
- Fig. 3:: eine erfindungsgemäße Dipolantennenanordnunge mit Abschirmkappe und Spulen in zwei verschiedenen geometrischen Anordnungen.

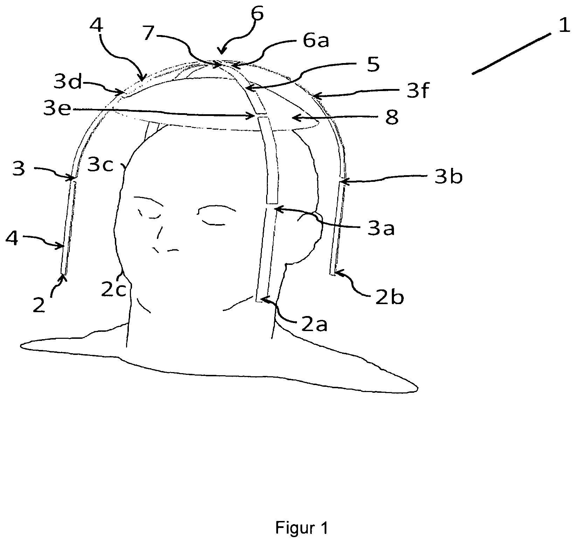

In Figur 1 ist eine Dipolantennenanordnung 1 mit vier Dipolantennenarmen 2, 2a, 2b, 2c dargestellt, bei der die Dipolantennenarme 2, 2a, 2b, 2c jeweils Kapazitäten/Induktivitäten 3, 3a, 3b, 3c, ...., 3e besitzen. Die Dipolantennenarme sind Bereiche von Dipolantennen 4, 5, die an ihrem Einspeisepunkt 6, durch Mittel zum Verbinden der Dipolantennen 7 elektrisch isolierend miteinander befestigt sind. In der Biegung befindet sich eine Abschirmkappe 8.

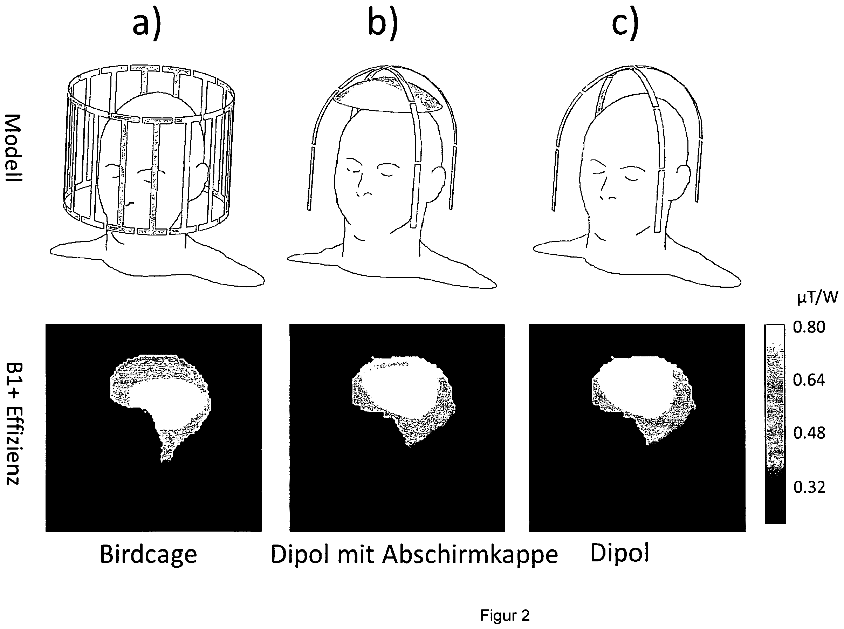

Figur 2 zeigt in Spalte a) eine Birdcage-Spule mit der Darstellung der zugehörigen B1 Effizienz. Spalte b) zeigt eine erfindungsgemäße Dipolantennenanordnung mit einer Abschirmkappe und deren B1 Effizienz im Vergleich. Spalte c) zeigt die gleichen Darstellungen für eine Dipolantennenanordnung ohne Abschirmkappe.

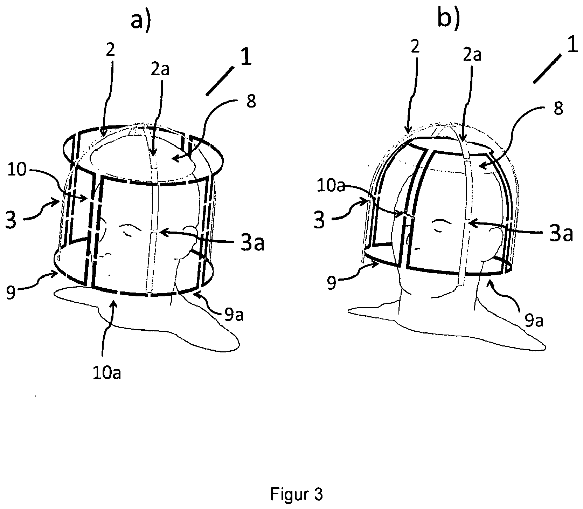

In Figur 3 haben gleiche Vorrichtungsmerkmale dieselben Bezugszeichen.
Seite a) zeigt eine Dipolantennenanordnung 1 mit Abschirmkappe 8. Die Dipolantennenarme 2, 2a, ... besitzen Kapazitäten 3, 3a. An die Dipolantennenanordnung 1 sind Oberflächenspulen 9, 9a, ... so angeordnet, dass sie durch die Dipolantennenarme 2, 2a, mittig geteilt werden. Die Spulen besitzen ebenfalls Kapazitäten 10, 10a, ....
Seite b) zeigt die gleiche Anordnung mit denselben Bezugszeichen, wie Seite a), jedoch sind die Spulen 9, 9a, ... der Krümmung der Dipolantennenarme 2, 2a nachgebildet.

### Beispiel:

Im Folgenden wird die Erfindung an einem Beispiel erläutert, ohne dass dies einschränkend auszulegen ist.

Es wird eine geometrisch entkoppelte Anordnung vorgeschlagen (Figur 1). Aufgrund der gebogenen Konfiguration weisen die Dipolantennen eine geometrische Grundschwingung bei 200 MHz auf. Die Eigenfrequenz kann mittel konzentrierter Spulen, welche in die Dipolstruktur eingefügt werden, auf eine klinische Feldstärke abgestimmt werden. Zusätzlich erlaubt eine Konfiguration mit zwei senkrechten Dipolantennen Quadraturbetrieb. Die Isolierung zwischen den beiden Dipolantennen in der hier gezeigten Ausführung beträgt 34 dB. Abbildung 2 zeigt ein Simulationsmodell von Birdcage-Spulen sowie den gebogenen Zweikanal-Dipolantennen und ihre B₁⁺ Feldverteilung. Tabelle 1 beschreibt das durchschnittliche B₁⁺ Feld im gesamten Gehirn bei Anregung mit identischer Eingangsleistung sowie die entsprechenden lokalen (10g) SAR Werte. Die gebogenen Dipolantennen liefern eine ähnliche durchschnittliche B₁⁺ Feldstärke im gesamten Gehirn, wobei das maximale B₁⁺ mehr zum oberen Teil des Gehirns fokussiert wird.

Gemäss der Erfindung wird die Dipolantenne mit Oberflächenspulen kombiniert, welche auf eine X-Kern Resonanz abgestimmt sind. Die Konfiguration wird in Figur 3 gezeigt. Tabelle 2 zeigt die Isolierung zwischen Dipolantennen und Oberflächenspulen. Die maximale Kopplung beträgt -27 dB. Die geometrische Entkopplung der beiden Anordnungen ist leicht realisierbar und bedarf keines anspruchsvollen Sperrkreises. 1H und X Systeme können beide gleichzeitig in Quadratur betrieben werden. Es tritt keine Verschlechterung des intrinsischen SNR der Einzelsysteme auf, da keine weiteren (verlustbehafteten) Komponenten zur Entkopplung in die Schaltung eingefügt werden müssen. Zusätzlich lässt sich die Anordnung auch für Entkopplungsexperimente nutzen.

Eine weiter bevorzugte Ausführungsform benutzt eine Abschirmkappe unterhalb des Speisepunkts der Dipolantennen, um die an diesem Punkt erzeugten konservativen elektrischen Felder abzuschirmen. Tabelle 1 verdeutlicht die Abschirmwirkung anhand der lokalen SAR Werte. Gebogene Dipolantennen erzeugen 1.95 W/kg maximale lokale SAR. Die Abschirmkappe reduziert diesen Wert auf 1.65 W/kg. Die Abschirmung von elektrischen Feldern mit leitenden Materialien ist im MRT Spulenbau gut bekannt. In dieser bevorzugten Ausführungsform dient die Abschirmung dem zweifachen Zweck, der Reduzierung des lokalen SAR und der Homogenisierung der B₁⁺ Feldverteilung durch die Unterdrückung der starken B₁⁺ Spitze unterhalb der Dipol Speisepunkte. Wirbelströme auf der Abschirmung können durch das Schlitzen der Abschirmung und die Verwendung von Kapazität zum Schließen des Hochfrequenz-Strompfads unterdrückt werden.

Das Hauptmerkmal der Erfindung ist eine gebogene Dipolantenne, welche die Nutzung von Dipolstrukturen bei klinischen Feldstärken ermöglicht. Konventionelle gerade Dipole können unterhalb von 4 T aufgrund ihrer Länge nicht benutzt werden. Gleichzeitig zerstört die Biegung der Dipolantennen in der vorgeschlagenen Weise nicht die symmetrische Feldverteilung des Dipols selbst, so dass geometrische Entkopplung mit zusätzlichen MRT Spulen möglich bleibt. Die bevorzugte Ausführungsform ist die Verwendung von mindestens zwei Dipolantennen, um einen Betrieb in Quadratur zu erreichen. Es ist zu beachten, dass in einer geraden Dipolanordnung mindestens vier Elemente auf einer zylindrischen Kreislinie benötigt werden, um eine kreisförmige Polarisation innerhalb des Zylinders zu erreichen (8). Der höhere SAR an den Speisepunkten der Dipolantennen im Vergleich mit einer Standard Birdcage-Spule kann durch die Verwendung einer leitenden Abschirmungskappe, welche einfach in die Spule integriert werden kann, reduziert werden. Diese Abschirmungskappe behindert nicht den Zugang zu Augen und Ohren eines Patienten, falls dies z.B. während einer funktionellen MRT Messung notwendig wird.

Hinzufügen von Oberflächenstrukturen - eine für beide Enden der gebogenen Dipole - resultiert in einer geometrisch entkoppelten Konfiguration, welche ideal für MRT mittels verschiedener Kerne geeignet ist. In dieser Anordnung, welche die Herstellung erleichtert und SNR optimiert, gibt es keinen Bedarf für Sperrkreise. Die vorgeschlagene Konfiguration mit vier Oberflächenspulen bietet ausreichend Platz für die Verwendung von Geräten zur funktionellen MRT (Kopfhörer, Brillen, etc.). Sie ist ebenfalls bestens geeignet für kombinierte PET-MR Messungen, da für Gammastrahlung hoch absorbierende Metallstrukturen nur in wenigen Raumbereichen auftreten und die Ansteuerung der 1H und X Spulensysteme außerhalb des field-of-view des PET Gerätes stattfinden kann.

Es wurde ein doppelt abgestimmtes 4 T 1H/31P Spulensystem aufgebaut. Die zwei gebogenen Dipole von 60 cm Länge, welche in Quadratur betrieben werden, sind dazu auf 160 MHz abgestimmt. Die Abstimmung der Dipolantennen erfolgt mittels Spulen am Speisepunkt. Die Quadraturisolierung zwischen den beiden Dipolen beträgt 34 dB. Die konservativen elektrischen Felder an den Dipol Speisepunkten werden mit einer gleichförmigen Metallscheibe (Abschirmungskappe) abgeschirmt. B₁⁺ Leistungsfähigkeit einer Protonen Birdcage-Spule und die abgeschirmte Dipolantennenstruktur liegen in derselben Größenordnung. Das lokale SAR ist bei der gebogenen Dipolantenne geringfügig höher im Vergleich zu einer Birdcage-Spule, jedoch erlauben diese Werte weiterhin eine sichere Nutzung innerhalb der gesetzlichen SAR Höchstgrenzen.

Die Dipolantennenstruktur wurde mit vier Oberflächenspulen kombiniert (Figur 3), welche auf die 31 P Frequenz bei 4 T (64 MHz) abgestimmt sind. Die Oberflächenspulen sind untereinander induktiv entkoppelt. Die durchschnittliche Entkopplung zwischen dem Protonen- und 31 P Kanal ist 49 dB bei 160 MHz und -8 dB bei 64 MHz (Tabelle 2). Das SNR der 31 P Oberflächenspulen ist identisch mit dem einer größengleichen Anordnung ohne die Dipolantennen.

**Tabelle 1**

| | Birdcage-Spule | Gebogene Dipolantenne mit Kappe | Gebogene Dipolantenne |
|---|---|---|---|
| Mittlere B₁⁺ ganzer Kopf (µT) | 0.665 | 0.634 | 0.657 |
| Maximales 10g SAR (W/kg) | 1.14 | 1.62 | 1.95 |

| | | | |
|---|---|---|---|
| Mittleres B1+ Feld bei gleicher Eingangsleistung und maximales lokales (10g) SAR normiert auf 1W akzeptierte Leistung pro Anordnung | | | |

**Tabelle 2**

| | 64MHz | | 160MHz | |
|---|---|---|---|---|
| | Mittel | Maximum | Mittel | Maximum |
| Isolierung zwischen Dipolen und Oberflächenspulen (dB) | 38 | 27 | 49 | 38 |

| | | | | |
|---|---|---|---|---|
| Entkopplung zwischen Dipolantennen und Oberflächenspulen Minimum | | | | |

## Patentansprüche

1. Dipolantennenanordnung (1) zur Entkopplung von 1H/X-Kern Resonanzen, bei der mindestens zwei Dipolantennen (4, 5) mechanisch, jedoch nicht elektrisch, miteinander verbunden sind, **dadurch gekennzeichnet, dass** sich die Dipolantennen (4, 5) an einem Kreuzungspunkt kreuzen und vom Kreuzungspunkt ausgehend Dipolantennenarme ausbilden, wobei die Dipolantennenarme in einem Halbraum angeordnet sind und dass an die Dipolantennenarme Oberflächenspulen (9, 9a) angebracht sind, welche auf die Resonanzfrequenz eines X-Kerns abgestimmt sind.

2. Dipolantennenanordnung nach Anspruch 1,
**dadurch gekennzeichnet,**
**dass** sie 3 bis 16 Dipolantennen besitzt.

3. Dipolantennenanordnung nach Anspruch 1 oder 2,
**dadurch gekennzeichnet,**
**dass** die Krümmung der Dipolantennen einen Halbkreis oder den Abschnitt eines Ovals beschreibt.

4. Dipolantennenanordnung nach einem der Ansprüche 1 bis 3,
**dadurch gekennzeichnet,**
**dass** sich die Dipolantennen in ihrer Mitte kreuzen.

5. Dipolantennenanordnung nach einem der Ansprüche 1 bis 4,
**dadurch gekennzeichnet,**
**dass** die Dipolantennenarme in dem Halbraum in dem sie sich befinden, Längslinien eines Zylinders oder eines Kegels ausbilden.

6. Dipolantennenanordnung nach einem der Ansprüche 1 bis 5,
**dadurch gekennzeichnet,**
**dass** die Dipolantennenarme Kapazitäten oder Induktivitäten (3, 3a, 3b, 3c, ..., 3e) beinhalten.

7. Dipolantennenanordnung nach einem der Ansprüche 1 bis 6,
**dadurch gekennzeichnet,**
**dass** sie über eine Abschirmkappe (8) verfügt.

8. Dipolantennenanordnung nach Anspruch 7,
**dadurch gekennzeichnet,**
**dass** die Abschirmkappe (8) am Kreuzungspunkt der Dipolantennen angebracht ist.

9. Dipolantennenanordnung nach einem der Ansprüche 7 oder 8,
**dadurch gekennzeichnet,**
**dass** die Abschirmkappe (8) am Einspeisepunkt der Dipolantennenanordnung angebracht ist, welcher vorgesehen ist, mit einem Generator verbunden zu werden.

10. Dipolantennenanordnung nach einem der Ansprüche 1 bis 9,
**dadurch gekennzeichnet,**
**dass** an mindestens einem Dipolantennenarm (2,2a,2b,2c) mindestens eine Oberflächenspule (9, 9a) angeordnet ist.

## Claims

1. A dipole antenna assembly (1) for decoupling 1H/X-core resonances, wherein at least two dipole antennas (4, 5) are connected to one another mechanically, but not electrically,
**characterized in**
**that** the dipole antennas (4, 5) intersect at an intersection point and form dipole antenna arms starting from the intersection point, wherein the dipole antenna arms are arranged in a half-space and that surface coils (9, 9a) are attached to the dipole antenna arms, which surface coils are tuned to the resonance frequency of a X-core.

2. The dipole antenna assembly according to claim 1,
**characterized in**
**that** it has 3 to 16 dipole antennas.

3. The dipole antenna assembly according to claim 1 or 2,
**characterized in**
**that** the curvature of the dipole antennas describes a semi-circle or the section of an oval.

4. The dipole antenna assembly according to any of claims 1 to 3,
**characterized in**
**that** the dipole antennas intersect in their center.

5. The dipole antenna assembly according to any of claims 1 to 4,
**characterized in**
**that** the dipole antenna arms in the half-space, in which they are located, form longitudinal lines of a cylinder or of a cone.

6. The dipole antenna assembly according to any of claims 1 to 5,
**characterized in**
**that** the dipole antenna arms contain capacitors or inductors (3, 3a, 3b, 3c, ..., 3e).

7. The dipole antenna assembly according to any of claims 1 to 6,
**characterized in**
**that** it possesses a shielding cover (8).

8. The dipole antenna assembly according to claim 7,
**characterized in**
**that** the shielding cover (8) is attached to the intersection point of the dipole antennas.

9. The dipole antenna assembly according to any of claims 7 or 8,
**characterized in**
**that** the shielding cover (8) is attached to the feed point of the dipole antenna assembly which is intended to be connected to a generator.

10. The dipole antenna assembly according to any of claims 1 to 9,
**characterized in**
**that** at least one surface coil (9, 9a) is arranged on at least one dipole antenna arm (2,2a,2b,2c).

## Revendications

1. Système (1) à antennes dipôles de découplage de résonance de noyau 1H/X, dans lequel au moins deux antennes (4, 5) dipôles sont reliées l'une à l'autre mécaniquement, mais non électriquement,
**caractérisé en ce que**
les antennes (4, 5) dipôles se croisent en un point d'intersection et constituent, à partir du point d'intersection, des bras d'antennes dipôles, le bras d'antennes dipôles étant disposés dans un demi espace, et **en ce que**, sur les bras d'antennes dipôles sont mises des bobines (9, 9a) de surface, qui sont accordées à la fréquence de résonance d'un noyau X.

2. Système à antennes dipôles suivant la revendication 1,
**caractérisé**
**en ce qu'**il possède de 3 à 16 antennes dipôles.

3. Système à antennes dipôles suivant la revendication 1 ou 2,
**caractérisé**
**en ce que** la courbure des antennes dipôles décrit un demi cercle ou la partie d'un ovale.

4. Système à antennes dipôles suivant l'une des revendications 1 à 3,
**caractérisé**
**en ce que** les antennes dipôles se croisent en leur milieu.

5. Système à antennes dipôles suivant l'une des revendications 1 à 4,
**caractérisé**
**en ce que** les bras des antennes dipôles constituent, dans le demi espace dans lequel ils se trouvent, des lignes longitudinales d'un cylindre ou d'un cône.

6. Système à antennes dipôles suivant l'une des revendications 1 à 5,
**caractérisé**
**en ce que** les bras des antennes dipôles comportent des capacités ou des inductances (3, 3a, 3b, 3c, ..., 3e).

7. Système à antennes dipôles suivant l'une des revendications 1 à 6,
**caractérisé**
**en ce qu'**il dispose d'une coiffe (8) de blindage.

8. Système à antennes dipôles suivant la revendication 7,
**caractérisé**
**en ce que** la coiffe (8) de blindage est mise au point d'intersection des antennes dipôles.

9. Système à antennes dipôles suivant l'une des revendications 7 ou 8,
**caractérisé**
**en ce que** la coiffe (8) de blindage est mise au point d'injection du système à antennes dipôles, qui est prévu pour être relié à un générateur.

10. Système à antennes dipôles suivant l'une des revendications 1 à 9,
**caractérisé**
**en ce qu'**au moins une bobine (9, 9a) de surface est mise sur au moins un bras (2, 2a, 2b, 2c) d'antennes dipôles.
